Europäisches Patentamt

(19) European Patent Office

Office européen des brevets

(11) Numéro de publication : **0 091 335**
**B1**

(12) **FASCICULE DE BREVET EUROPÉEN**

(45) Date de publication du fascicule du brevet :
30.12.86

(21) Numéro de dépôt : 83400573.8

(22) Date de dépôt : 18.03.83

(51) Int. Cl.⁴ : **H 05 K 7/20, H 01 R 23/70**

(54) **Système d'interconnexion thermique.**

(30) Priorité : 26.03.82 FR 8205251

(43) Date de publication de la demande :
12.10.83 Bulletin 83/41

(45) Mention de la délivrance du brevet :
30.12.86 Bulletin 86/52

(84) Etats contractants désignés :
DE GB IT

(56) Documents cités :
US-A- 3 631 325
US-A- 4 214 292
US-A- 4 298 904
US-A- 4 322 776

(73) Titulaire : SOCAPEX
10 bis, quai Léon Blum
F-92153 Suresnes (FR)

(72) Inventeur : Bricaud, Hervé
THOMSON-CSF SCPI 173, bld Haussmann
F-75379 Paris Cedex 08 (FR)
Inventeur : Casses, Claude
THOMSON-CSF SCPI 173, bld Haussmann
F-75379 Paris Cedex 08 (FR)

(74) Mandataire : Brullé, Jean et al
Service Brevets Bendix 44, rue François 1er
F-75008 Paris (FR)

## Description

La présente invention concerne un système d'interconnexion thermique principalement destiné aux armoires électriques comportant une grande densité de cartes imprimées revêtues de composants électriques dissipant des calories. La demande française FR-A-2 477 828 déposée le 7 mars 1980 décrit un système d'interconnexion thermique et électrique pour des armoires électriques comportant une pluralité de cartes imprimées « mères » et « filles ».

De telles armoires électriques comportant un grand nombre de cartes « mères » et cartes « filles » généralement situées à proximité les unes des autres posent d'importants problèmes de dissipation thermique. En effet, les composants utilisés à l'heure actuelle comportent un très grand nombre de fonctions sous forme intégrée responsables d'une importante dissipation thermique. La proximité des cartes les unes des autres nécessite une organisation dans l'évacuation des calories et une répartition la plus uniforme possible de la température dans l'ensemble de l'armoire électrique. Les systèmes de connexions thermique et électrique actuellement connus présentent principalement l'inconvénient d'être difficilement réparables en cas de pannes, dans de bonnes conditions, les opérations de maintenance étant particulièrement longues et difficiles à réaliser.

On connaît, par le brevet US-A-4 214 292, un système de connexion thermique et électrique comportant un châssis sur lequel est disposée une pluralité de parois parallèles solidaires du châssis entre lesquelles vient s'encliqueter un connecteur thermique constitué essentiellement par des lames ressorts.

Le système d'interconnexion thermique selon l'invention permet d'éviter ces inconvénients. Il est caractérisé en ce que les connecteurs thermiques comportent au moins un tenon perpendiculaire à l'axe du connecteur qui coopère avec une rainure complémentaire réalisée dans les parois parallèles parallèlement à l'axe du connecteur de manière à réaliser le montage et la fixation du connecteur en faisant coulisser le tenon dans la rainure. De préférence, le châssis est formé par un profilé d'aluminium dans lequel viennent se loger les connecteurs de cartes qui sont maintenus solidaires de ce profilé sans aucune vis de fixation. Les opérations de montage des armoires électriques correspondantes ainsi que la maintenance sont donc particulièrement simplifiées en utilisant le système selon l'invention.

L'invention sera mieux comprise à l'aide des exemples de réalisation suivants donnés à titre non limitatif, conjointement avec les figures qui représentent :

la figure 1 une vue d'ensemble d'une armoire électrique comportant un système d'interconnexion selon l'art antérieur,

la figure 2 une première variante de réalisation du système d'interconnexion thermique selon l'invention,

la figure 3 une deuxième variante de réalisation du système selon l'invention,

la figure 4 une troisième variante du système d'interconnexion selon l'invention,

la figure 5 divers modes de refroidissement possibles du système selon l'invention.

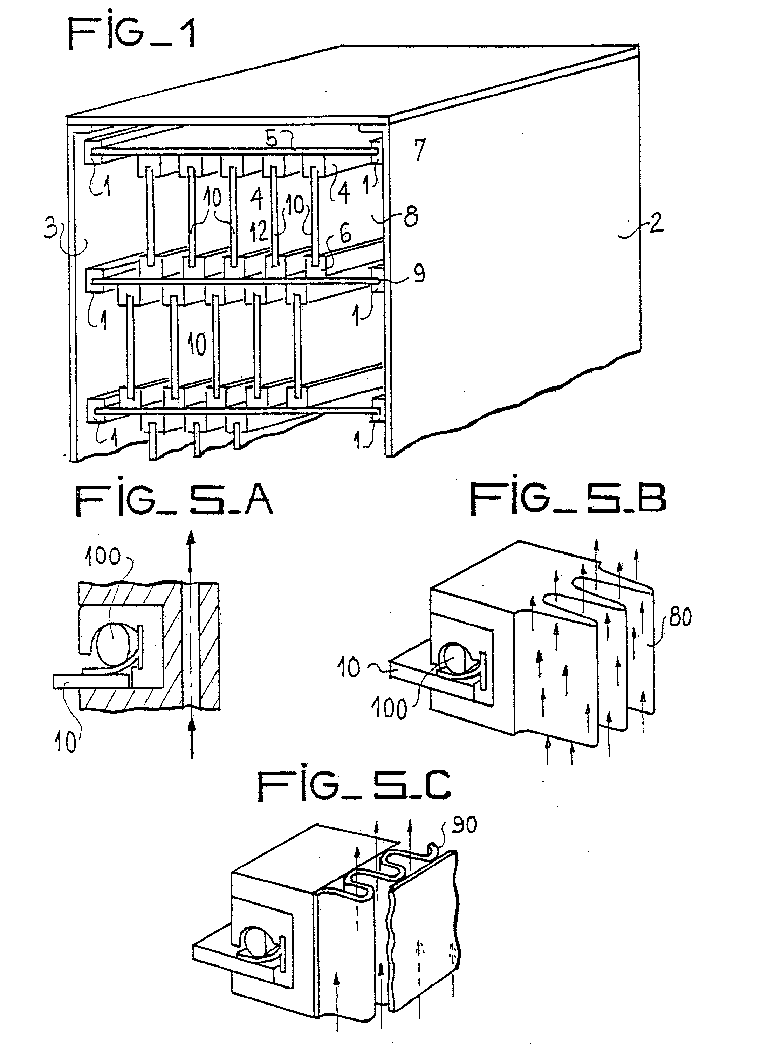

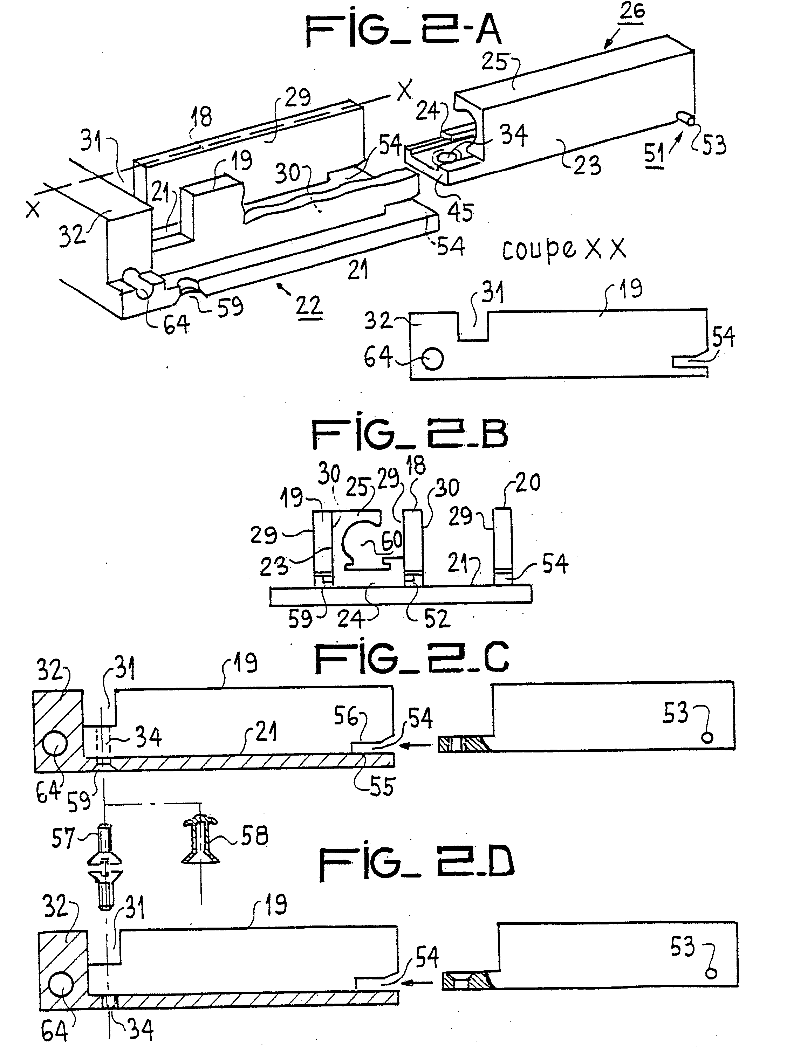

Sur la figure 1, est représentée une armoire électrique comportant un système de cartes « mères » et cartes « filles » selon l'art antérieur. Sur les parois latérales 2 et 3 de l'armoire électrique, sont fixés une pluralité de connecteurs thermiques et/ou électriques 1. Ces connecteurs 1 sont disposés en saillie sur les parois latérales de l'armoire. Entre deux connecteurs 1, sont disposées des cartes mères 5. Ces cartes mères comportent généralement un circuit électrique rapporté sur un drain thermique qui permet l'interconnexion électrique et thermique des cartes filles telles que 10 fixées parallèlement entre elles entre deux cartes mères 5, chaque carte fille étant maintenue à l'une de ses extrémités par un connecteur électrique et/ou thermique 11, 12 solidaire d'une carte mère 5. Chaque connecteur est en saillie par rapport à la carte mère. La fixation de ces connecteurs sur les parois latérales ou sur les cartes mères s'effectue donc à l'aide de vis ou rivets qui solidarisent ainsi les deux parties. Lorsqu'une panne électrique et/ou thermique se produit par exemple au niveau d'un connecteur tel que 1 ou 12, il est donc nécessaire pour la maintenance de ce système de démonter et d'extraire de l'appareil électrique au moins une carte mère et l'ensemble des connecteurs 12 fixés sur celle-ci ainsi que l'ensemble des cartes filles 10 reliées auxdits connecteurs 12. Il est ensuite nécessaire de dévisser le connecteur défectueux et le remplacer par un nouveau connecteur puis remonter l'ensemble.

La figure 2 représente une première variante du système selon l'invention. Sur la figure 2a, est représentée une vue partielle d'une paroi 22 destinée à remplacer par exemple une carte mère 5 de la figure 1. Cette paroi 22 est constituée d'une partie plane 21 formant la paroi proprement dite sur laquelle sont fixées parallèlement entre elles une pluralité de parois verticales 18, 19, 20. Ces parois verticales telles que 18 et 19 comportent chacune les faces latérales 29 et 30 en contact avec le connecteur thermique 26. Ces parois latérales de même hauteur que la hauteur de la paroi latérale 23 du connecteur 26 se prolongent à l'arrière de celles-ci par une paroi commune 32, séparées toutefois de celle-ci par un espace rectangulaire 31. Cette paroi 32, qui peut bien entendu se prolonger verticalement sur la figure de manière à former une armoire métallique complète, est traversée par au moins une canalisation 64 dans laquelle circule un fluide de refroidissement. Le connecteur 26 a sensiblement la forme d'un U comportant deux branches 24 et 25 d'inégales longueurs, reliées par une branche 23 représentant la base du U. La longueur de la branche 25 est inférieure à celle de la branche 24 de manière à permettre l'introduction de la carte imprimée entre l'extrémité de cette branche 25 et la paroi latérale 29 de la paroi 18 (figure 2b), cette carte imprimée étant fixée par l'action d'une came non représentée sur la figure qui pivote dans le logement 60 prévu à cet effet. Les deux parois 18 et 19 permettent le glissement du connecteur 26 entre elles et le maintien latéral de celui-ci. L'extrémité 45 du connecteur 26 comporte une partie sensiblement plane, prolongement du bras 24, dans laquelle est prévue une ouverture 34 pour la fixation à l'aide d'une vis 57 ou d'un rivet 58 de manière à solidariser le connecteur du trou 59 de la paroi froide 21. L'ouverture sensiblement rectangulaire 31 est prévue dans ce but afin de pouvoir atteindre plus aisément cette vis de fixation. L'autre extrémité du connecteur 26 est réalisée par un assemblage de deux tenons 52 et 53 qui viennent coopérer avec deux ouvertures 54 réalisées dans les parois telles que 18 et 19. Ces tenons 52 et 53 sont disposés sensiblement sur un même axe 51 qui traverse la paroi 24. Les ouvertures 54 sont munies d'un chanfrein d'entrée et ont une forme sensiblement rectangulaire comme représentée sur la figure. Bien entendu, la longueur de chaque tenon 52, 53 n'excède pas la moitié de la largeur d'une ouverture 54 (voir figure 2b).

Ce premier mode de réalisation du système selon l'invention permet une fixation simple des connecteurs 26 tandis que l'ensemble de la paroi froide 22 peut être obtenu directement à l'aide d'un profil extrudé.

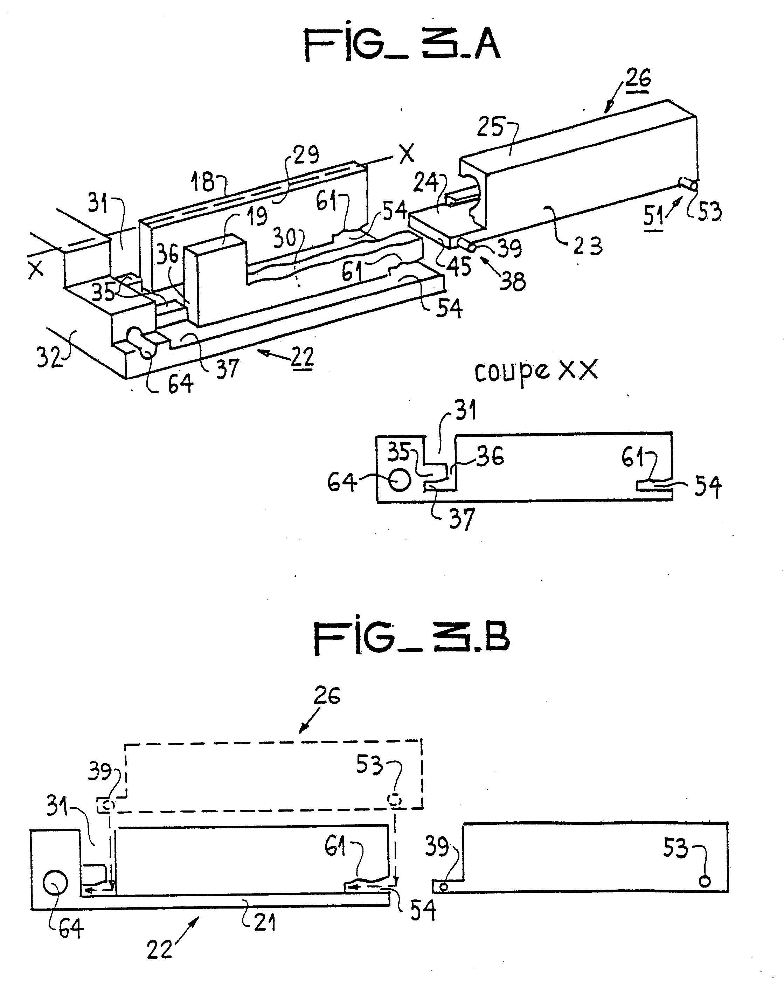

La figure 3 représente une deuxième variante de réalisation du système selon l'invention, figure sur laquelle les mêmes éléments que ceux des figures précédentes portent les mêmes références. Dans cette seconde variante, la différence essentielle réside dans le mode de fixation de la partie avant 45 du connecteur 26. Celle-ci est munie de tenons tels que 39 disposés le long d'un axe 38 traversant la paroi 24. Ces tenons 39 sont destinés à coopérer avec le logement 37 situé dans l'ouverture 31. Pour cela, cette ouverture de forme généralement rectangulaire possède sur sa face latérale gauche (coupe XX figure 3) une saillie 35 délimitant un passage étroit 36 légèrement supérieur à l'épaisseur du tenon 39, cette saillie délimitant le logement 37 de forme sensiblement rectangulaire muni d'un chanfrein d'entrée. Les longueurs des logements 37 et 54 sont identiques (dans le sens horizontal sur la figure) pour permettre un déplacement commun des tenons 53 et 39. La fixation s'effectue (figure 3b) en amenant le tenon 39 du connecteur 26 à l'aplomb du passage 36 de l'ouverture 31, puis mouvement vertical du connecteur 26 et enfin translation horizontale dudit connecteur de manière à faire coulisser les tenons 39 et 53 dans les logements 37 et 54. Afin d'éviter la désolidarisation du connecteur et de la paroi froide 22 dans le cas de chocs ou de vibrations, il est prévu une encoche 61 dans l'ouverture 54, celle-ci étant de section suffisamment faible par rapport au diamètre du tenon 53 pour nécessiter un enclenchement en force de celui-ci qui vient ensuite se loger dans cette cavité semi-cylindrique 61 (on peut aussi réaliser cet encliquetage par un enclenchement à force du tenon dans la rainure 54 résultant d'un léger décalage de l'axe 51 du tenon 53 de manière à déformer légèrement l'axe 51 avant son redressement lors de son arrivée dans le logement 61). On note que ce type d'assemblage est très simple et très pratique à réaliser, aucune vis de fixation n'étant prévue, tandis que la forme de la paroi 52 peut également être obtenue directement par extrusion.

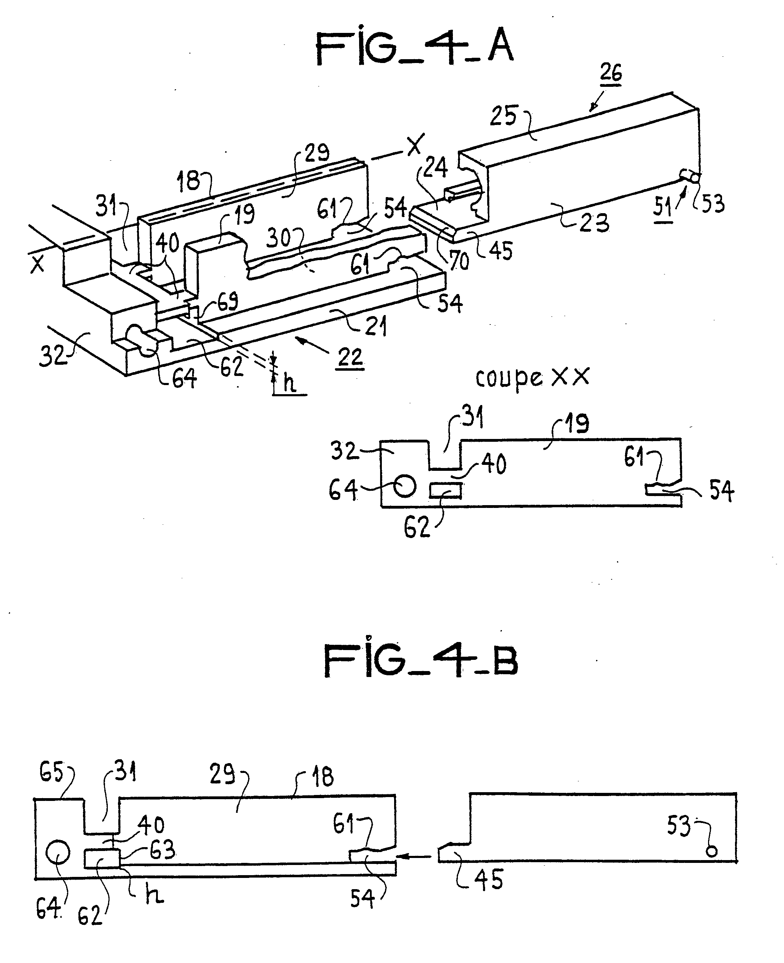

La figure 4 représente une troisième variante de réalisation du système selon l'invention, sur laquelle les mêmes éléments que ceux des figures précédentes portent les mêmes références. Cette variante se distingue de celle de la figure 2 par son mode de fixation de la partie avant 45 du connecteur 26 dans la paroi froide 22. Pour cela, le profilé obtenu directement d'extrusion a la forme indiquée sur la figure (coupe XX). On constate sur cette figure que l'ouverture rectangulaire 31 entre une paroi 19 et la paroi 32 est limitée par une traverse 40 sous laquelle on trouve une seconde ouverture 62. Cette ouverture (figure 4a) s'étend continûment sur la paroi 21, sensiblement parallèlement à la canalisation 64. La largeur de la paroi 40 n'est pas constante (figure 4b) pour permettre de déboucher dans la rainure 62 en fraisant la rainure. Au niveau des parois telles que 18, 19, 20, etc..., cette traverse 40 relie cette paroi à la paroi arrière 32, tandis qu'au niveau correspondant à un intervalle entre deux parois 18 et 19, cette traverse 40 est légèrement en retrait par rapport au flanc latéral droit de l'ouverture 31 (partie hachurée de la traverse 40 sur la figure 4b). Le connecteur 26, quant à lui, comporte une partie avant 45 de sa face 24 munie d'un chanfrein d'entrée 70. La hauteur de la cavité 63 correspond sensiblement à l'épaisseur de cette face d'entrée 45. Toutefois, pour faciliter l'introduction du connecteur 26, la rainure 62 est à sa face inférieure légèrement en contrebas par rapport à la surface 21 de la paroi froide 22 (hauteur h sur la figure 4a). L'ouverture 63 (figure 4b) correspondant à l'introduction de la face avant 45 du connecteur 26 est réalisée par usinage, le profilé obtenu directement d'extrusion comportant une traverse 40 de largeur constante et fermée également le long de la paroi 69 (figure 4a).

Cette dernière solution présente l'avantage par rapport aux deux solutions précédentes de ne nécessiter qu'un seul axe tel que 51 dans le connecteur 26, tout en permettant un assemblage plus aisé des connecteurs et de la paroi froide 22 (un seul mouvement longitudinal) ainsi qu'une meilleure continuité thermique des parois verticales avec le puits thermique 64 en particulier lorsque celui-ci est situé à l'extrémité (gauche sur la figure) de la paroi froide 22. Bien entendu, d'autres canalisations telles que 64 peuvent exister à l'intérieur même de la paroi 21 régulièrement

réparties de celles-ci.

La figure 5 représente des exemples de réalisation de sources froides faisant intervenir différents types de puits thermiques tels que 64. Ces exemples illustrent particulièrement bien la nécessité et l'utilité de l'invention, et en particulier les solutions des figures 3 et 4. En effet, si dans le cas de la figure 5a qui correspond au cas des figures précédentes, le refroidissement est réalisé par circulation d'un fluide, l'utilisation de vis est malgré tout possible dans la mesure où ces vis telles que 57 (figure 2) sont disposées en dehors des passages du liquide de refroidissement. Toutefois, dans des cas de refroidissement tels que représentés sur les figures 5b et 5c correspondant à un refroidissement par circulation d'air (figure 5b) et circulation d'air canalisé (figure 5c), il est aisé de comprendre que l'implantation de vis de fixation devant déboucher entre les ailettes de refroidissement par circulation d'air (figure 5b) et circulation d'air canalisé (figure 5c), il est aisé de comprendre que l'implantation de vis de fixation devant déboucher entre les ailettes de refroidissement des radiateurs 80 ou 90 poserait de sérieux problèmes. Le système selon l'invention permet donc à la fois une maintenance plus aisée et augmente les possibilités de refroidissement du système.

## Revendications

1. Système d'interconnexion thermique pour l'interconnexion d'une pluralité de cartes imprimées revêtues de composants électriques et munies d'un drain thermique comportant une paroi (21) munie de moyens de refroidissement thermiques (64), appelée ci-après paroi froide, sur une face de laquelle sont disposées une pluralité de parois parallèles (18, 19, 20), perpendiculaires à la paroi froide entre lesquelles viennent se loger des connecteurs thermiques (26) sur lesquels peuvent être fixées des cartes imprimées, caractérisé en ce que lesdits connecteurs thermiques (26) comportent au moins un tenon (53) perpendiculaire à l'axe du connecteur, ledit tenon coopérant respectivement avec une rainure (54) réalisée dans une des parois parallèles (18, 19, 20) parallèlement à l'axe du connecteur de manière à réaliser le montage et la fixation du connecteur en faisant coulisser le tenon dans la rainure.

2. Système d'interconnexion selon la revendication 1, caractérisé en ce que la hauteur des parois parallèles (18, 19, 20) est sensiblement identique à celle du connecteur (26) qui vient se loger entre elles.

3. Système d'interconnexion selon l'une des revendications 1 ou 2, caractérisé en ce que le connecteur thermique (26) a une section en U dont la base (23) s'appuie contre l'une des parois parallèles (18, 19, 20), les branches du U étant d'inégale longueur, la branche la plus longue (24) étant au contact de la paroi froide (21), la branche la plus courte (25) ménageant un espacement entre son extrémité et l'autre paroi parallèle entourant le connecteur pour le passage de la carte imprimée, le connecteur comportant en outre des moyens de fixation (100) de celle-ci.

4. Système d'interconnexion selon l'une des revendications 1 à 3, caractérisé en ce que chaque connecteur (26) comporte deux tenons (52, 53) disposés sur un même axe traversant la branche du U de plus grande longueur (24), ces tenons étant disposés vers la partie arrière du connecteur, tandis que les parois parallèles qui l'entourent comportent chacune une rainure (54) qui coopère avec le tenon, réalisée parallèlement à l'axe du connecteur, le système comportant en outre des moyens de verrouillage (61) du tenon et de la fente.

5. Système d'interconnexion selon l'une des revendications 1 à 4, caractérisé en ce que chaque connecteur comporte deux tenons disposés sur un même axe traversant la branche du U de plus grande longueur, deux saillies (35) étant disposées dans une paroi arrière (32) qui est perpendiculaire aux parois parallèles, perpendiculaire à la paroi froide et disposée sur la paroi froide de manière à ménager un logement qui coopère avec lesdits tenons.

6. Système d'interconnexion selon l'une des revendications 1 à 5, caractérisé en ce que la partie avant de chaque connecteur comporte une partie plane (45), dans le prolongement de la branche de plus grande longueur du U, qui vient s'encastrer dans une cavité (63) réalisée entre la paroi froide (21) et une traverse (40) parallèle à la paroi froide et reliant les parois parallèles à une paroi arrière (32) qui est perpendiculaire aux parois parallèles, perpendiculaire à la paroi froide et disposée sur la paroi froide, cette cavité débouchant sur une rainure (62) dont le fond est situé en contrebas par rapport à la surface supérieure de la paroi froide, de manière à permettre une introduction aisée du connecteur.

## Claims

1. Thermal interconnection system for interconnecting a plurality of printed cards provided with electric components and with a thermal drainage comprising a wall (21) provided with cooling means (called cooling wall hereinafter) on one face of which there is disposed a plurality of parallel walls (18, 19, 20) perpendicular to the cooling wall, between which there are received thermal connectors (26), with the printed cards being fixed thereto, characterized in that said thermal connectors (26) comprise at least one pin (53) perpendicular to the axis of the connector, said pin cooperating respectively with a groove (54) provided in one of the parallel walls (18, 19, 20) parallel to the axis of the connector such that mounting and fixing of the connector is obtained by having the pin slided into the groove.

2. Interconnection system according to claim 1, characterized in that the height of the parallel walls (18, 19, 20) is substantially identical to that of the connector (26) which is received therebetween.

3. Interconnection system according to any of claims 1 or 2, characterized in that the thermal connector (26) is of U shape, the basis (23) of the U engaging one of the parallel walls (18, 19, 20), the legs of the U being of different lengths, with the leg (24) of greater length being in contact with the cooling wall (21) and the leg (25) of smaller length providing a space between its end and the other parallel wall enclosing the connector for the passage of the printed card, the connector further comprising means (100) for fixing the latter.

4. Interconnection system according to any of claims 1 to 3, characterized in that each connector (26) comprises two pins (52, 53) along a same axis traversing the leg (24) of greater length of the U, said pins being disposed towards the rear portion of the connector, while the parallel walls enclosing it each comprise a groove (54) which cooperates with the pin and is parallel to the axis of the connector, the system further comprising means (61) for locking the pin and the groove.

5. Interconnection system according to any of claims 1 to 4, characterized in that each connector comprises two pins disposed along a same axis traversing the leg of greater length of the U, two projections (35) being disposed in a rear wall (32) which is perpendicular to the parallel walls, perpendicular to the cooling wall and disposed on the cooling wall such as to provide a pocket cooperating with said pins.

6. Interconnection system according to any of claims 1 to 5, characterized in that the forward portion of each connector comprises a plane portion (45) as an extension of the leg of greater length of the U, which is received in a cavity (63) provided between the cooling wall (21) and a traverse member (40) parallel to the cooling wall and connecting the parallel walls to a rear wall (32) which is perpendicular to the parallel walls, perpendicular to the cooling wall and disposed on the cooling wall, said cavity opening into a groove (62) having a bottom which is downwardly offset with respect to the upper surface of the cooling wall such as to allow for ease of insertion of the connector.

**Patentansprüche**

1. Thermisches Verbindungssystem zum Verbinden mehrerer bedruckter Karten, auf denen elektrische Bauteile aufgebracht sind und die mit einer Wärmeableitung in Form einer mit Kühlmitteln (64) versehenen Kühlwand (21) versehen sind, wobei auf einer Seite der Kühlwand mehrere parallele, zur Kühlwand senkrecht verlaufende Wände (18, 19, 20) angeordnet sind, zwischen denen thermische Verbinder (26) untergebracht sind, auf denen bedruckte Karten befestigbar sind, dadurch gekennzeichnet, daß die thermischen Verbinder (26) mindestens einen Stift (53) aufweisen, der senkrecht zur Achse des Verbinders verläuft, wobei der Stift mit einer Nut (54) zusammenwirkt, die in einer der parallelen Wände (18, 19, 20) parallel zur Achse des Verbinders gebildet ist, derart, daß die Montage und Befestigung des Verbinders durch Einschieben des Stiftes in die Nut erfolgt.

2. Verbindungssystem nach Anspruch 1, dadurch gekennzeichnet, daß die Höhe der parallelen Wände (18, 19, 20) im wesentlichen gleich ist der Höhe des zwischen ihnen angeordneten Verbinders (26).

3. Verbindungssystem nach Anspruch 1 oder 2, dadurch gekennzeichnet, daß der thermische Verbinder (26) einen Querschnitt in Form eines U hat, dessen Verbindungssteg (23) an einer der parallelen Wände (18, 19, 20) anliegt, während die Schenkel des U ungleiche Länge haben, wobei der längere Schenkel (24) an der Kühlwand (21) anliegt und der kürzere Schenkel (25) zwischen seinem Ende und der den Verbinder umgebenden anderen parallen Wand einen Zwischenraum für den Durchtritt der bedruckten Karte bildet, wobei der Verbinder außerdem Befestigungsmittel (100) für diese aufweist.

4. Verbindungssystem nach einem der Ansprüche 1-3, dadurch gekennzeichnet, daß jeder Verbinder (26) zwei Stifte (52, 53) aufweist, die auf einer den längeren Schenkel (24) des U durchquerenden gleichen Achse angeordnet sind, wobei diese Stifte zum hinteren Abschnitt des Verbinders hin angeordnet sind, während die ihn umgebenden parallelen Wände jeweils eine parallel zur Achse des Verbinders verlaufende Nut (54) aufweisen, die mit dem Stift zusammenwirkt, wobei das System außerdem Mittel (61) zum Verriegeln von Stift und Schlitz aufweist.

5. Verbindungssystem nach einem der Ansprüche 1-4, dadurch gekennzeichnet, daß jeder Verbinder zwei Stifte aufweist, die auf einer den längeren Schenkel des U durchquerenden gleichen Achse angeordnet sind, wobei zwei Vorsprünge (35) in einer Rückwand (32) angeordnet sind, die senkrecht zu den parallelen Wänden und senkrecht zu der Kühlwand verläuft und auf der Kühlwand angeordnet ist, derart, daß sie eine mit den Stiften zusammenwirkende Aufnahme bilden.

6. Verbindungssystem nach einem der Ansprüche 1-5, dadurch gekennzeichnet, daß der vordere Abschnitt jedes Verbinders in der Verlängerung des längeren Schenkels des U einen ebenen Abschnitt (45) aufweist, der in eine Ausnehmung (63) eingepaßt ist, die zwischen der Kühlwand (21) und einer Traverse (40) gebildet ist, die parallel zur Kühlwand verläuft und die parallelen Wände mit einer Rückwand (32) verbindet, welche senkrecht zu den parallelen Wänden und senkrecht zur Kühlwand verläuft und auf der Kühlwand angeordnet ist, wobei diese Ausnehmung in einer Nut (62) mündet, deren Boden bezüglich der Oberseite der Kühlwand nach unten versetzt ist, derart, daß der Verbinder bequem einführbar ist.

## FIG_1

## FIG_5.A

## FIG_5.B

## FIG_5.C

# FIG_2-A

coupe XX

# FIG_2_B

# FIG_2_C

# FIG_2_D

# FIG_ 3.A

coupe XX

# FIG_ 3.B

# FIG_4_A

coupe XX

# FIG_4_B